**Europäisches Patentamt**

**European Patent Office**

**Office européen des brevets**

(19)

(11) Veröffentlichungsnummer: **0 000 202**
**B1**

(12) **EUROPÄISCHE PATENTSCHRIFT**

(45) Veröffentlichungstag der Patentschrift: **25.11.81**

(21) Anmeldenummer: **78100279.5**

(22) Anmeldetag: **29.06.78**

(51) Int. Cl.³: **G 03 C 5/02, B 41 B 27/00, G 03 F 1/00**

(54) Vorrichtung zur Kontrolle von Strichstärkenänderung von Schriften, welche mit Hilfe einer Fotosatzanlage herstellbar sind.

(30) Priorität: **30.06.77 CH 8083/77**

(43) Veröffentlichungstag der Anmeldung:
**10.01.79 Patentblatt 79/1**

(45) Bekanntmachung des Hinweises auf die Patenterteilung:
**25.11.81 Patentblatt 81/47**

(84) Benannte Vertragsstaaten:
**BE CH DE FR GB LU NL SE**

(56) Entgegenhaltungen:
**CH - A - 554 751**
**US - A - 3 631 772**
**US - A - 3 998 639**

(73) Patentinhaber: **Brunner, Felix**
**CH-6611 Corippo (CH)**

(72) Erfinder: **Brunner, Felix**
**CH-6611 Corippo (CH)**

(74) Vertreter: **Freiherr von Schorlemer, Reinfried et al,**
**Brüder-Grimm-Platz 4**
**D-3500 Kassel (DE)**

Courier Press, Leamington Spa, England.

## Vorrichtung zur Kontrolle von Strichstärkenänderung von Schriften, welche mit Hilfe einer Fotosatzanlage herstellbar sind.

Die Erfindung betrifft eine Vorrichtung zur Kontrolle von Strichstärkenänderung von Schriften, welche mit Hilfe einer Fotosatzanlage herstellbar sind.

Seit einigen Jahren findet in der grafischen Branche eine beschleunigte Ablösung des Bleisatzes durch den Fotosatz statt. Es lässt sich der Zeitpunkt abschätzen, ab welchem in Mittel- und Westeuropa nur noch Bücher bibliophilen Charakters ab Blei gedruckt werden. Denn die genannte neue Technik bringt den grafischen Betrieben bedeutende Zeit- und Platzersparnisse. Sie bringt jedoch auf der anderen Seite auch neue technische Probleme mit sich. Insbesondere stellt sich das Problem der Qualitätssicherung im Fotosatz anders als im Bleisatz.

Das Setzen im Fotosatz geschieht heuzutage zur Hauptsache mit Hilfe einer Lichtquelle, eines Schriftspiechers (Fotosatzschriftträger), einer Grössen- und Dickteneinrichtung sowie einer oder zwei Kassetten für das Fotomaterial.

Beim Projektionsfotosatz leuchtet eine Lichtquelle (Glühlicht oder Blitzlicht) ein Zeichennegativ aus und projiziert es im gewünschten Massstab über eine Grössenoptik auf fotografisches Material.

Beim Strahlfotosatz baut die Aufzeichnungslichtquelle, die einen lenkbaren Kathoden- oder Laserstrahl enthält, das Zeichen in gewünschter Grösse strich- oder punktweise auf dem Fotomaterial auf. Sie übernimmt das "Fahrprogramm" dabei von einer anderen Lichtquelle, die ein Zeichennegativ abtastet. Es können jedoch auch digital gespeicherte Informationen den Aufzeichnungsstrahl lenken. Beim Strahlfotosatz besteht das belichtete Zeichen (Buchstabe) also aus veilen Strichen bzw. Linien bzw. Punkten, die sich von blossem Auge nur deshalb nicht einzeln ausmachen lassen, weil dessen Auflösungsvermögen dazu nicht ausreicht.

Untersucht man die qualitätsbestimmenden Merkmale der Schriftwiedergabe, so findet man zwei Gruppen von Mängeln: Eine erste Gruppe umfasst Fehler in der Positionierung der Schriftzeichen, eine zweite Gruppe die Deformation der Schriftzeichen. Positionierungsfehler sind schiefe Buchstaben, schlechte Zeilenhaltung, unregelmässige Buchstabenabstände (Dickten) und unregelmässiger Durchschuss. Die Deformation der Schrift wirkt sich als Eckenabrundung, verbunden mit einem Verlust der Innen- und Aussenformen, als Abbrechen von Serifen, als Konturunschärfe und als Strichstärkenänderung.

Unerwünschte Strichstärkenänderungen haben zur Folge, dass einzelne Buchstaben, Wörter, Zeilen oder ganze Textabschnitte und Textseiten fetter oder magerer erscheinen als beabsichtigt. Drucksachen, welche derartige Mängel aufweisen, wirken ungepflegt, zudem wird die Lesbarkeit herabgesetzt, weil der Leser unsicher wird, ob eine fettere Zeile eine beabsichtigte Hervorhebung im Text bedeutet oder auf einen unbeabsichtigten technischen Mangel zurückzuführen ist. Die Vermeidung unerwünschter und ausserhalb der vom Auge noch akzeptierten Toleranz liegender Strichstärkenänderungen ist deshalb in der Qualitätssicherung des Fotosatzes von grosser Bedeutung.

Strichstärkenänderungen können auf verschiedenen Produktionsstufen auftreten: Das optische System der Belichtungseinheit der Fotosatzanlage kann Mängel aufweisen und demzufolge unregelmässige Ergebnisse liefern, die Lichtquelle selber kann Schwankungen oder Alterungserscheinungen unterliegen, was sich meist unverzüglich als Strichstärkenänderung im Satz auswirkt. Im weiteren kann die verwendete Fotosatzfilmemulsion Schwankungen aufweisen oder die Filmentwicklung kann zu unterschiedlichen Resultaten führen, was wiederum als Strichstärkenänderung in Erscheinung tritt. Bei der Kopie des Fotosatzfilmes auf die Offsetdruckplatte können ebenfalls Strichstärkenänderungen auftreten, ebenso beim nachfolgenden Druckvorgang selber.

Für die Messung von Strichstärkenänderungen im Fotosatz sind im wesentlichen zwei Methoden bekannt:
1) die messmikroskopische Methode und
2) die densitometrische Methode.

Bei der messmikroskopischen Methode wird ein Mikroskop verwendet, welches rund 100-fach oder mehr vergrössert und welches eine Messeinteilung von 0,01 mm oder feiner besitzt. Damit kann die Strichbreite von Buchstaben direkt gemessen werden. Die Methode ist geeignet um die Toleranzen der Strichstärkenänderung, welche vom Auge des Lesers noch akzeptiert wird, zu ermitteln. Zur Ueberwachung der einmal festgelegten Toleranzen in der täglichen Betriebspraxis ist die Methode jedoch umständlich und aufwendig. Mikroskope mit 100-facher Vergrösserung sind bereits Laborinstrumente und für Fachleute des Fotosatzes ungewohnt. Das Gesichtsfeld ist dabei so klein, dass davon in der Regel nicht einmal ein ganzer Buchstabe erfasst wird, was das Aufsuchen geeigneter Messstellen in der Schrift erschwert.

Die densitometrische Methode beruht auf der Erkenntnis, dass Schriftverbreiterung und Rasterpunktverbreiterung die gleichen Ursachen haben und demzufolge mit den gleichen Messmethoden erfasst werden können. Eine Rasterpunktverbreiterung bewirkt, dass ein Rasterfeld dunkler wird und demzufolge bei der Messung mit dem Densitometer einen höheren Dichtewert angibt.

Bringt man auf dem Fotosatzschriftträger an der Stelle, die sonst ein Buchstabennegativ einnehmen würde, ein geeignetes Rasterfeld, z.B. ein Mikromessfeld, und belichtet ein solches Rasterfeld in der gleichen Weise wie ein Buchstabe auf den Fotosatzfilm, so kann diese Feld nach dem Entwickeln mit einem Densitometer gemessen werden. Bei einer stärkeren Belichtung, welche eine Strichstärkenzunahme der Buchstaben einerseits und ein Dunklerwerden des Rasterfeldes andererseits zur Folge hat, zeigt das Densitometer einen höheren Wert an. Bei einer schwächeren Belichtung, welche eine Strichstärkenabnahme und ein Hellerwerden das Rasterfeldes zur Folge hat, erscheint am Densitometer ein niedrigerer Dichtewert.

Die beiden beschriebenen Messmethoden sind geeignet, um einerseits Standardwerte für die Strichstärke festzulegen und andererseits die vom Auge noch akzeptierten Toleranzen der Strichstärkenänderung zu ermitteln. Es verden Toleranzwerte festgelegt, was mit Hilfe von Testreihen geschieht.

Eine solche Testreihe kann folgendermassen hergestellt werden: Für eine bestimmte Schriftart und -grösse wird durch Versuche zuerst diejenige Strichstärke festgelegt, welche ein optimales Schriftbild in bezug auf Lesbarkeit und Aussehen ergibt. Mit der festgelegten Strichstärke werden mehrere Fotosatztextblöcke belichtet. Innerhalb dieser Textblöcke werden einzelne Zeilen jedoch gezielt mit anderen Belichtungszeiten belichtet, so dass diese Zeilen entweder magerer oder fetter erscheinen als der übrige Text. Testpersonen bestimmen dann die kritische Strichstärkenänderung, bei welcher fettere oder magerere Zeilen oder Texte für das Auge störend in Erscheinung treten.

Die kritische Strichstärkenänderung, welche in der Folge Strichstärkentoleranz genannt werden soll, ändert sich geringfügig von Schriftart zu Schriftart und auch mit dem Schriftgrad. Grössere Grade erlauben eine etwas grössere Strichstärkentoleranz als kleinere. Die Strichstärkentoleranz kann in Mikrometern oder in Dichtedifferenzen an einem definierten Rasterfeld angegeben werden.

Sollwert und Toleranz der Strichstärke können für jede Schriftart und jeden Grad nach den beschriebenen Methoden festgelgt werden. Da es sich dabei jeweilen un eine einmalige Aufgabe handelt, fällt der notwendige Aufwand und Zeitbedarf nicht ins Gewicht. Anders verhält es sich jedoch mit der täglichen Ueberwachung der einmal festgelegten Sollwerte und Toleranzen in der Betriebspraxis des Fotosatzes. Hier erscheinen die genannten Methoden wegen der notwendigen täglichen Wiederholung mühsam und aufwendig. In der Praxis besteht deshalb das Bedürfnis nach einer Vorrichtung, welche es erlaubt, die Kontrolle der Sollwerte und Toleranzen rasch und mit einfachen Mitteln durchzuführen.

Es sind bereits Vorrichtungen zur Kontrolle der Qualität eines aus Rasterpunkten bestehenden, in einem Reproduktions- und Druckverfahren zu verarbeitenden und auf einem Träger befindlichen Bildes bekannt, die aus wenigstens einem Meßelement mit wenigstens einem Meßsymbol bestehen, das so ausgebildet ist, daß das Verschwinden eines Teils desselben unmittelbar ein Maß für die relative Flächenvergrößerung der Rasterpunkte des Bildes ist (CH—PS 554 751). Derartige Vorrichtungen lassen sich jedoch nicht ohne weiteres auf die Kontrolle der Sollwerte und Toleranzen der Schriftstärke beim Fotosatz anwenden, weil Fotosatzschriften nicht wie Bilder aus einer Vielzahl von einzelnen Rasterpunkten bestehen und weil beim Fotosatz andere Kriterien als bei der Reproduktion oder beim Druck zu beachten sind.

Der Erfindung liegt die Aufgabe zugrunde, eine Vorrichtung zur raschen und einfachen Kontrolle der Schriftstärkenänderung einer mit einer Fotosatzanlage herstellbaren Fotosatzschrift zu schaffen.

Zur Lösung dieser Aufgabe ist die erfindungsgemäße Vorrichtung gekennzeichnet durch ein helles Kontrollfeld mit mehr als einem dunklen Flächenelement, wobei der kleinste Abstand von wenigstens zwei Flächenelementen und die kleinste Breite der Flächenelemente so gewählt sind, daß bei Überschreiten einer vorgegebenen Schriftstärkentoleranz der Abstand zwischen den Flächenelementen und bei Unterschreiten dieser Toleranz die Flächenelemente verschwinden.

Weitere vorteilhafte Merkmale der Erfindung sind in den Unteransprüchen gekennzeichnet.

Die Erfindung schafft erstmals eine Kontrollvorrichtung, mittels derer beim Fotosatz das Erreichen der oberen und unteren Schriftstärkentoleranz unmittelbar sichtbar gemacht werden kann. Eine solche Vorrichtung kann daher in vorteilhafter und einfacher Weise dazu benutzt werden, jedem Schrifttyp eine eigene, von seinen speziellen Eigentümlichkeiten abhängige Toleranz zuzuordnen und auf diese Weise sicherzustellen, daß beim Fotosatz jeder Schrifttyp innerhalb der ihm zugeordneten Toleranz wiedergegeben wird.

Nachstehend werden Ausführungsbeispiele der vorliegenden Erfindung anhand der beiliegenden Zeichnungen näher erläutert. Es zeigt:

Fig. 1 in starker Vergrößerung einen Ausschnitt aus einem Fotosatzschriftträger, welcher den Buchstaben "i" sowie zwei Ausführungsformen der vorliegenden Kontrollvorrichtung trägt,

Fig. 2 denselben Ausschnitt, der sich nun auf einem belichteten und entwickelten Fotosatzfilm befindet, wobei dieser Ausschnitt durch Projektion enstanden ist,

Fig. 3 den Ausschnitt nach Fig. 2, bei welchem eine Strichstärkenzunahme eingetreten ist,

Fig. 4 einen Ausschnitt nach Fig. 2, bei welchem eine Strichstärkenabnahme eingetreten ist,

Fig. 5 in starker Vergrößerung eine weitere Ausführungsform der vorliegenden Kontrollvorrichtung, welche ähnlich wie die Vorrichtung nach Fig. 2 durch Projektion enstanden ist, und

Fig. 6 die Vorrichtung nach Fig. 5, bei welcher eine Strichstärkenzunahme eingetreten ist.

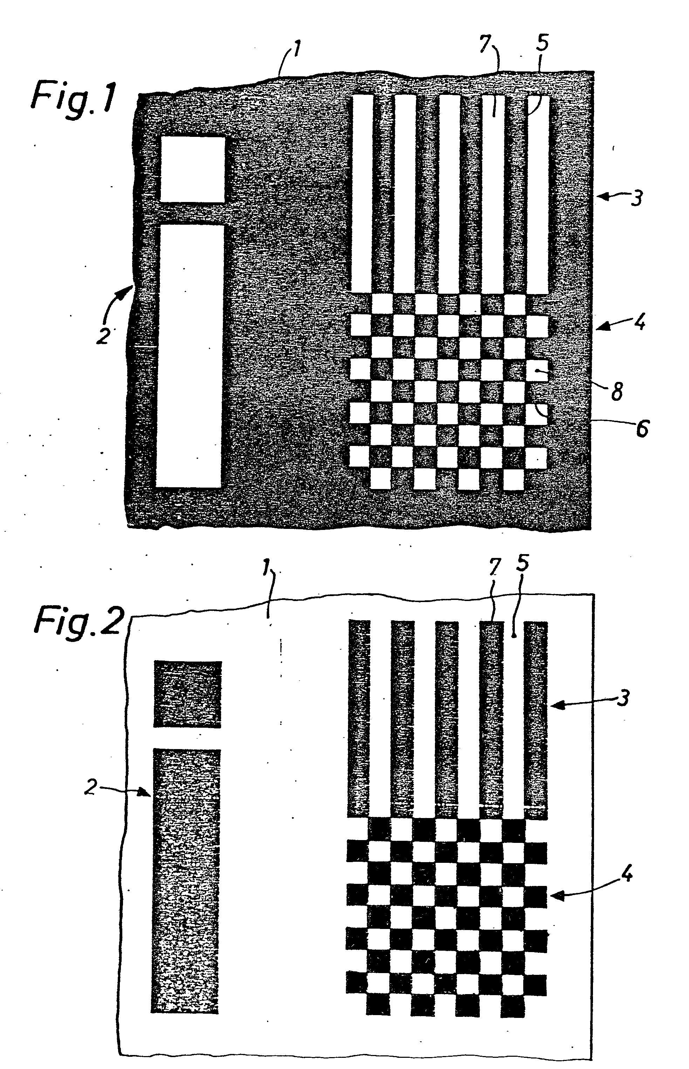

In Fig. 1 ist ein Ausschnitt aus einem Fotosatzschriftträger 1 in starker Vergrößerung dargestellt. Auf diesem Träger 1, der meist aus Glas ist, sind ein Buchstabe i, bezeichnet mit 2, sowie zwei mögliche Ausführungsformen 3 und 4 der vorliegenden Kontrollvorrichtung dargestellt. Die schwarzen Flächen 5 bzw. 6 sind bei diesen Kontrollvorrichtungen lichtundurchlässig, die weißen Flächen 7 bzw. 8 sind hingegen transparent.

Die erste Ausführungsform 3 der Kontrollvorrichtung hat die Form eines Linienrasters. Die zweite Ausführungsform 4 der Kontrollvorrichtung hat die Form eines sogenannten Quadratrasters. Die Breite der deckenden und der transparenten Linien bzw. Quadrate dieser Kontrollvorrichtungen ist dabei gleich gross wie die Strichstärkentoleranz derjenigen Schriftart, welche auf dem betreffenden Fotosatzschriftträger vorhanden ist.

Aus Fig. 1 ist ferner ersichtlich, dass die Breite der deckenden und der transparenten Linien 5,7 bzw. Quadrate 6,8 dieser Kontrollvorrichtung praktisch 1/3 der Breite des Buchstabens i beträgt. Die Länge der Linien 5 bzw. 7 bei der ersten Ausführungsform der vorliegenden Kontrollvorrichtung ist zwar kleiner als die Höhe des jeweiligen Buchstabens 2, diese Länge kann jedoch entweder gleich gross oder unter Umständen sogar grösser als die Höhe des Buchstabens sein.

Was die Anzahl dieser Linien 5 bzw. 7 anbelangt, sind selbstverständlich wenigstens zwei Flächenelemente 5 bzw. 7 erforderlich. Es versteht sich wohl, dass die Kontrolle der Strichstärkenänderung umso leichter erfolgen kann, je mehr Linien 5 und 7 bzw. Quadrate 6 und 8 die jeweilige Kontrollvorrichtung enthält.

Wie ersichtlich, enthält die vorliegende Kontrollvorrichtung wenigstens ein Rasterfeld 3 bzw. 4, dessen Rasterpunkte 6 bzw. 8 oder Rasterlinien 5 bzw. 7 in bezug auf deren Breite und deren kleinste Abstände genau der Strichstärkentoleranz entsprechen. Dieses Rasterfeld 3 bzw. 4 wird beim Fotosetzen wei ein Buchstabe am Ende einer Zeile oder einer Textspalte auf dem Fotosatzschriftträger 1 mitbelichtet und mitentwickelt. Tritt während der Belichtung und Entwicklung des Fotosatzfilmes eine Strichstärkenzunahme ein, welche die kritische Grenze, also die Strichstärkentoleranz erreicht, so verbreitern sich gleichzeitig die feinen Linien oder Rasterpunkte im Rasterfeld der Kontrollvorrichtung in der Weise, dass die Zwischenräume gerade gefüllt werden, und das Feld dadurch zu einer schwarzen Vollfläche wird, was von blossem Auge oder mit einer Lupe einfach festgestellt werden kann.

Tritt umgekehrt bei der Belichtung und Entwicklung des Fotosatzfilmes eine Strichstärkenabnahme ein, welche die untere Toleranzgrenze erreicht, so verschmälern sich die feinen Linien oder Rasterpunkte im Rasterfeld der Kontrollvorrichtung soweit, dass diese vollständig verschwinden, was ebenfalls einfach festgestellt werden kann.

Die Kontrollvorrichtung erlaubt damit, Mängel im Fotosatzfilm in bezug auf die Strichstärkentoleranz unmittelbar nach dem Entwickeln des Filmes zu erkennen. Infolgedessen kann ein solcher Fotosatzfilm vor der Weiterverarbeitung rechtzeitig ausgeschieden werden, während sonst der Mangel meist erst am fertigen Druckresultat erkennbar wird, wobei dann der Schaden viel grösser ist. Die vorliegende Kontrollvorrichtung erlaubt auch eine Beurteilung wie ein als fehlerhaft erkannter Fotosatzfilm wiederholt werden muss, damit der festgestellte Mangel in der Wiederholung nicht mehr vorhanden ist.

Diese nun geschilderte Anwendungsweise der vorliegenden Kontrollvorrichtung sowie eine noch weitere Ausführungsform derselben werden nun noch näher beschrieben und erörtert.

Fig. 2 zeigt ein Teilstück aus einem belichteten und entwickelten Fotosatzfilm, welcher durch Projektion des Musters nach Fig. 1 entstanden ist. In diesem Fall trat keine Strichstärkenänderung auf, und deswegen sind die Breiten sowohl des Buchstaben i als auch der abgebildeten Kontrollvorrichtungen 3 und 4 unverändert, jedoch im fotografischen Sinne positiv. Die abgebildeten Kontrollvorrichtungen 3 und 4 sind noch als Rasterfeld vorhanden.

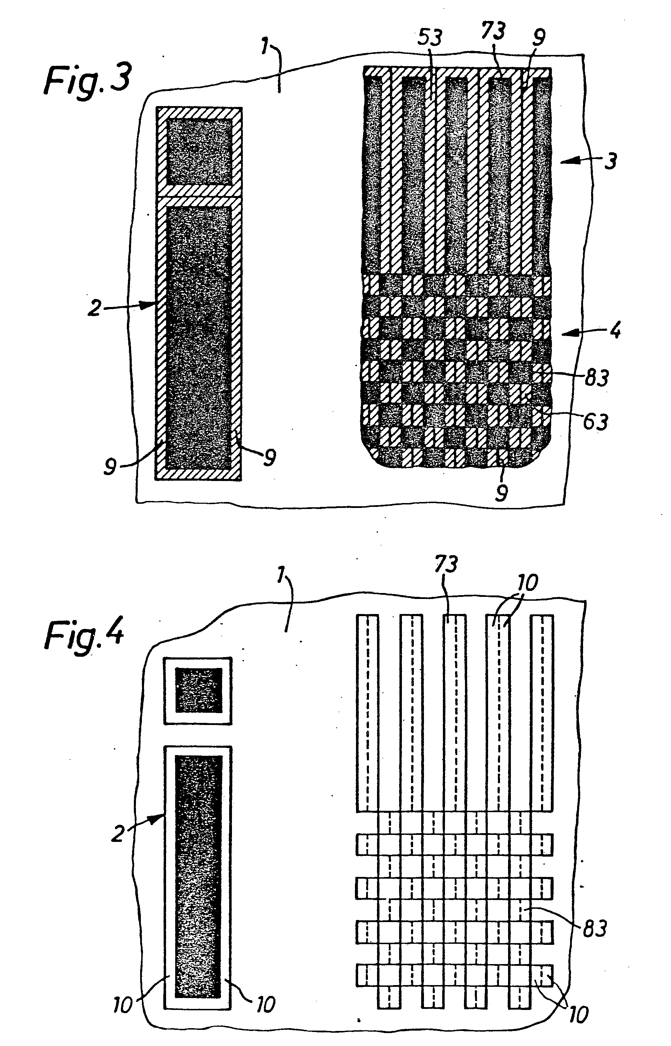

Fig. 3 zeigt das entsprechende Teilstücke aus einem belichteten und entwickelten Fotosatzfilm, wobei eine Strichstärkenzunahme eingetreten ist, welche in der Strichstärkentoleranz liegt. Aus dem Buchstaben i, welcher mit 2 bezeichnet ist, ist durch Hinzukommen einer Kontur 9 ein fetterer Buchstabe entstanden. Die Summe von zwei einander gegenüberliegenden Konturbreiten 9 ist dabei gleich gross angenommen, wie die Strichstärkentoleranz. Die gleiche Zunahme 9 ist in dieser Fig. 3 auch bei den Linien 73 und den Quadraten 83 der Kontrollvorrichtungen 3 und 4 feststellbar. Die Konturen 9 füllen dabei gerade den Zwischenraum 63 bzw. 53 zwischen den Rasterpunkten 73 bzw. 83 der Kontrollvorrichtungen 3 und 4 aus, da ja dieser Abstand gleich gross ist, wie die Strichstärkentoleranz. Die Rasterfläche der Kontrollvorrichtungen wird dabei auf dem Fotosatzfilm als Vollfläche abgebildet, was optisch leicht zu erkennen ist.

Fig. 4 zeigt das entsprechende Teilstück 1 aus einem belichteten und entwickelten Fotosatzfilm, wobei eine Strichstärkenabnahme eingetreten ist, welche gerade der Strichstärkentoleranz entspricht. Aus dem Buchstaben i, bezeichnet mit 2, ist durch Wegfallen einer Kontur 10 ein schmälerer Buchstabe entstanden. Die Summe der beiden einander gegenüber liegenden Konturen 10 ist dabei gleich gross, wie die Strichstärkentoleranz. Die gleiche Abnahme wurde auch an den Linien 53 und Quadraten 83 der Kontrollvorrichtungen wirksam. Die Konturen 10 bewirken dabei, dass die Breite der Linien 73 und Rasterpunkte 83 der Kontrollvorrichtungen auf Null sinkt, so dass diese verschwinden. Die Rasterfläche der Kontrollvorrichtungen wird dabei auf dem Fotosatzfilm als Leerfläche abgebildet, was optisch leicht erkennbar ist.

In den vorstehend beschriebenen einfachen Fällen wird von der Annahme ausgegangen, das Zusammenfallen bzw. Wegfallen der Linien bzw. der Rasterelemente der Kontrollvorrichtungen geschehe allein auf Grund einer Strichstärkenzunahme oder -abnahme bei der Belichtung und Weiterverarbeitung des Fotosatzfilmes. Dieser einfachste Fall setzt voraus, dass das Auflösungsvermögen des optischen Systems der Fotosatzanlage sowie das Auflösungsvermögen der verwendeten fotografischen Schichten unendlich hoch sei, oder mindestens sehr viel höher liegt, als die Strichstärkentoleranz.

Das Auflösungsvermögen als physikalische Grösse wird bekanntlich in Linienpaaren pro Zentimeter oder pro Millimeter angegeben und definiert damit die feinste Strichbreite, welche noch wiedergegeben werden kann. Das Auflösungsvermögen von Fotosatzanlagen und der üblichen Fotosatzfilme ist in der Regel beschränkt. Aus diesem Grunde verschwinden die Linien oder Rasterpunkte der Kontrollvorrichtung nicht erst dann, wenn die Strichstärkentoleranz unter bzw. überschritten, sondern bereits dann, wenn die durch das Auflösungsvermögen gesetzte Grenze erreicht wird. Um diesem Umstande Rechnung zu tragen, wird in der beschriebenen Kontrollvorrichtung die Breite der Kontrollelemente — Linien oder Rasterpunkte — so gewählt, dass diese der Summe der beiden Breiten entspricht, welche sich einerseits aus der Strichstärkentoleranz und andererseits aus dem Auflösungsvermögen ableiten lassen.

Ein Beispiel soll diesen Sachverhalt näher erläutern: Die Strichstärkentoleranz für einen bestimmten Schriftgrad betrage ± 6 Mikrometer. Die Breite der Linien und deren Abstände in der Kontrollvorrichtung müsste ohne Berücksichtigung des Auflösungsvermögens demzufolge 6 Mikrometer betragen. Das Auflösungsvermögen des angewandten Fotosatzsystems betrage 500 Linienpaare pro Zentimeter.

Ein Linienpaar, das gerade noch abgebildet werden kann, hat demzufolge eine Gesamtbreite von 20 Mikrometer, die einzelne positive oder negative Linie demzufolge eine solche von 10 Mikrometer. Feinere Linien können nicht mehr abgebildet werden, sie verschwinden oder fallen zu einer Fläche zusammen. Die Strichbreite der Linien oder der Durchmesser der Rasterpunkte in der Kontrollvorrichtung muss demzufolge 6 plus 10 = 16 Mikrometer betragen.

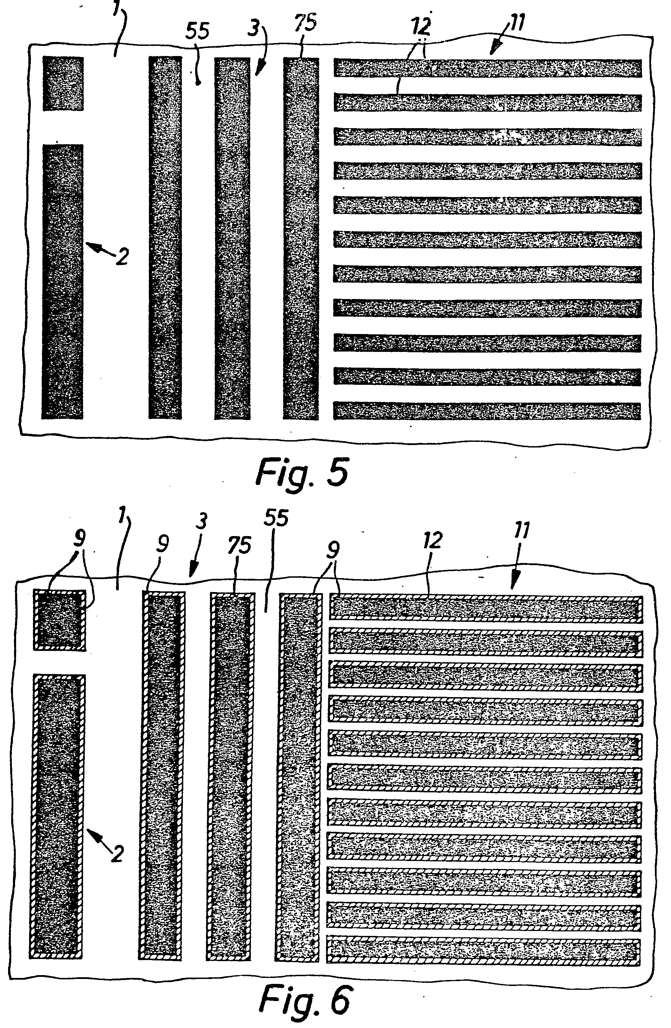

Eine weitere Ausführungsform der vorliegenden Kontrollvorrichtung ist in Fig. 5 und 6 dargestellt. In Fig. 5 ist die erste der Kontrollvorrichtungen 3 aus Fig. 1 samt dem Buchstaben i, bezeichnet mit 2, dargestellt. Diese Kontrollvorrichtung 3 ist in Fig. 5 so abgebildet, wie sie aus der in Fig. 1 dargestellten Kontrollvorrichtung 3 durch Projektion dieser entsteht. Diesem Kontroll-bzw. Rasterfeld 3, dessen Rasterpunkte oder -linien 75 den Strichstärkentoleranzen entsprechen, wird ein weiteres Kontroll- bzw. Rasterfeld 11 an die Seite gestellt. Die Rasterpunkte oder -linien 12 dieses weiteren Kontroll- bzw. Rasterfeldes 11 sind zwar feiner oder gröber, sie bilden jedoch zusammen eine Fläche mit gleichem Tonwert, d.h. mit gleicher Flächenbedeckung, wie das beim erstgenannten Rasterfeld 3 der Fall ist. Der kleinste Durchmesser der bandförmigen Flächenelemente der ersten Kontrollvorrichtung 3 und deren kleinster Abstand 55 ist grösser (im vorliegenden Beispiel doppelt so gross) als die entsprechenden Flächenelemente 12 im zusätzlichen Kontrollfeld 11. Die Flächenelemente 75 bilden in ihrer Gesamtheit das erste Feld 3, die Flächenelemente 12 bilden dagegen zusammen das zweite Feld 11. Die Flächenbedeckung der beiden Felder 3 und 11 in bezug auf ihre Flächenelemente 25 bzw. 12 ist gleich gross, und im dargestellten Beispiel beträgt sie praktisch 50%. Dies bedeutet, dass die Flächenelemente je 50% der Gesamtfläche des jeweiligen Feldes 3 bzw. 11 bedecken, dem sie zugehören. Die beiden Felder 3 und 11 können aber auch eine voneinander unterschiedliche Gesamtfläche besitzen.

Visuell erscheinen die beiden solchermassen ausgeformten Rasterfelder 3 und 11 in der gleichen Helligkeitsstufe, sie unterscheiden sich jedoch durch ihre Rasterfeinheit und demzufolge in ihrem Verhalten bei Strichstärkenänderungen. Tritt mämlich während eines Uebertragungsvorganges im Fotosatz eine Strichstärkenveränderung ein, so verbreitern oder verschmälern sich sowohl die Linien 75 bzw. 12 oder Rasterpunkte des ersten wie auch des zweiten Rasterfeldes 3 bzw. 11. Da jedoch das Rasterfeld mit seinen gröberen Linien oder Rasterpunkten aus geometrischen Gründen eine geringere Summe von Randzonen pro Flächeneinheit aufweist, bewirkt die Strichstärkenveränderung in diesem gröberen Rasterfeld eine geringere Tonwertverschiebung als im feineren Rasterfeld. Demzufolge tritt zwischen den beiden Rasterfeldern ein Helligkeits- oder Tonwertunterschied auf, welcher vom Auge wahrgenommen wird, welcher aber auch mit einem Densitometer gemessen werden kann. Wird das erste Rasterfeld gegenüber dem zweiten gröberen Rasterfeld dunkler, so ist eine Strichstärkenzunahme erfolgt, wird es umgekehrt heller, ist eine Strichstärkenabnahme erfolgt. Behalten beide Felder den gleichen Tonwert, so ist keine Strichstärkenveränderung eingetreten.

Da im Feld 11 die sogenannte Summe der Randzone der Flächenelemente grösser ist (im dargestellten Beispiel doppelt so gross) als im Feld 3, bewirkt die gleiche Strichstärkenzunahme in diesem Feld eine stärkere Flächenzunahme als im benachbarten Feld 3, und demzufolge auch ein stärkeres Dunklerwerden. Fig 6 soll diesen Sachverhalt deutlicher machen. Aus dem Buchstaben i, der mit 2 bezeichnet ist, ist durch das Hinzukommen einer Kontur 9 ein fetterer Buchstabe geworden. Die gleichen Konturen 9 sind auch bei den bandförmigen Flächenelementen 53 bzw. 12 der Felder 3 und 11 hinzugekommen. Da das Feld 11 jedoch mehr Flächenelemente 12 besitzt, (doppelt so viele) wie das erste Feld 3, erfährt es eine stärkere Tonwertzunahme durch diese hinzugefügten Konturen als das Feld 3. Der Tonwertunterschied ist visuell oder densitometrisch feststellbar und dient als Mass für die Strichstärkenänderung.

**Patentansprüche**

1. Vorrichtung zur Kontrolle der Strichstärkenänderung einer mit einer Fotosatzanlage herstellbaren Fotosatzschrift, gekennzeichnet durch ein helles Kontrollfeld mit mehr als einem dunklen Flächenelement, wobei der kleinste Abstand von wenigstens zwei Flächenelementen und die kleinste Breite der Flächenelemente so gewählt sind, daß bei Überschreiten einer vorgegebenen Schriftstärkentoleranz der Abstand zwischen den Flächenelementen und bei Unterschreiten dieser Toleranz die Flächenelemente verschwinden.

2. Vorrichtung nach Anspruch 1, dadurch gekennzeichnet, daß der kleinste Abstand und die kleinste Breite der Flächenelemente so gewählt sind, daß bei Überschreiten bzw. Unterschreiten der vorgegebenen Strichstärkentoleranz plus der Strichstärke der feinsten Linie, welche durch eine Fotosatzanlage, in welcher die Vorrichtung verwendet werden soll, noch wiedergegeben werden kann, der Abstand zwischen den Flächenelementen bzw. die Flächenelemente verschwinden.

3. Vorrichtung nach Anspruch 1 oder 2, dadurch gekennzeichnet, daß die Flächenelemente die Form eines Bandes, einer Kreisfläche, eines Rechtecks oder eines Quadrats aufweisen.

4. Vorrichtung nach einem der Ansprüche 1 bis 3, dadurch gekennzeichnet, daß neben dem Kontrollfeld ein zweites Kontrollfeld vorhanden ist, welches mehr als ein Flächenelement aufweist, wobei der kleinste Abstand von wenigstens zwei Flächenelementen und die kleinste Breite wenigstens eines Flächenelements kleiner oder größer als die entsprechenden Breiten oder Abstände der Flächenelemente im ersten Kontrollfeld sind.

5. Vorrichtung nach einem der Ansprüche 1 bis 4, dadurch gekennzeichnet, daß die Flächenelemente nach Art eines Linien- und/oder Punktrasters angeordnet sind, bei dem die Breite und der Abstand der Rasterlinien oder Rasterpunkte der Strichstärkentoleranz entspricht.

**Claims**

1. Apparatus for controlling the stroke strength variations of a photoset document produced with a photo-setting installation, characterised by a light control field with more than one dark surface element, wherein the minimum gap between at least two surface elements and the minimum breadth of the surface elements are so selected that, on exceeding a predetermined stroke strength the gap between the surface elements disappears and, on falling below this tolerance, the surface elements disappear.

2. Apparatus according to claim 1, characterised in that the minimum gap and the minimum breadth of the surface elements are so selected that, on exceeding and falling below the predetermined stroke strength tolerance plus the stroke strength of the finest line which can be reproduced by a photo-setting installation in which the apparatus is to be used, the gap between the surface elements and the surface elements respectively disappear.

3. Apparatus according to claim 1 or 2, characterised in that the surface elements have the form of a strip, a circular surface, a rectangle or a square.

4. Apparatus according to one of claims 1 to 3, characterised in that, besides the control field, a second control field is provided which comprises more than one surface element, wherein the minimum gap between at least two surface elements and the minimum breadth of at least one surface element are smaller or greater than the corresponding breadth or gap of the surface elements in the first control field.

5. Apparatus according to one of claims 1 to 4, characterised in that the surface elements are arranged in the manner of a raster of lines and/or points, in which the breadth and the spacing of the raster lines or raster points correspond to the stroke strength tolerance.

**Revendications**

1. Dispositif pour contrôler la variation d'épaisseur de trait d'un caractère de typographie photographique qu'on peut produire au moyen d'une installation de photo-composition, caractérisé par un champ clair de contrôle avec plus d'une surface élémentaire sombre, la plus petite distance d'au moins deux surfaces élémentaires et la plus petite largeur des surfaces élémentaires étant choisies de telle manière que, lors du passage au-dessus ou dépassement d'une tolérance d'épaisseur de trait prédéterminée, les distances entre les surfaces élémentaires disparaissent et lors du passage en dessous de cette tolérance les surfaces élémentaires disparaissent.

2. Dispositif selon la revendication 1, caractérisé en ce que la plus petite distance et la plus petite largeur des surfaces élémentaires sont choisies de telle manière que, lors du passage au-dessus ou au-dessous de la tolérance prédéterminée d'épaisseur de trait augmentée de l'épaisseur de trait de la ligne la plus fine qui peut encore être reproduite au moyen d'une installation de photo-composition dans laquelle le dispositif doit être utilisé, les distances entre les surfaces élémentaires ou les surfaces élémentaires disparaissent.

3. Dispositif selon la revendication 1 ou la revendication 2, caractérisé en ce que les surfaces élémentaires ont la forme d'une bande, d'une surface circulaire, d'un rectangle ou d'un carré.

4. Dispositif selon l'une quelconque des revendications 1 à 3, caractérisé en ce qu'en plus du champ de contrôle est prévu un deuxième champ de contrôle qui présente plus d'une surface élémentaire, la plus petite distance d'au moins deux surfaces élémentaires et la plus petite largeur d'au moins une surface élémentaire étant plus petites ou plus grandes que les largeurs ou distances correspondantes des surfaces élémentaires du premier champ de contrôle.

5. Dispositif selon l'une quelconque des revendications 1 à 4, caractérisé en ce que les surfaces élémentaires sont disposées à la manière d'une trame de lignes ou de points, pour laquelle la largeur et la distance des lignes ou points de la trame correspondent à la tolérance d'épaisseur de trait.

**0 000 202**

Fig.1

Fig.2

Fig.3

Fig.4

0 000 202

**Fig. 5**

**Fig. 6**